# DEMANDE DE BREVET EUROPEEN

(11) **EP 0 869 593 A1**
(43) Date de publication de la demande: **07.10.1998**
(21) Numéro de dépôt: 98400708.8
(22) Date de dépôt: 26.03.1998
(51) Int. Cl.: H01S 3/085

(54) **Laser semiconducteur à émission de surface**

(30) Priorité: 03.04.1997 FR 9704074
(71) Demandeur: ALCATEL ALSTHOM COMPAGNIE GENERALE D'ELECTRICITE, 75008 Paris (FR)
(72) Inventeur: Brillouet, François, 92140 Clamart (FR); Jacquet, Joel, 91470 Limours (FR); Salet, Paul, 92140 Clamart (FR); Goldstein, Léon, 92370 Cherville (FR); Garabedian, Patrick, 29 Avenue de la République 91290 Arpajon (FR); Starck, Christophe, 91700 Ste-Genevieve-Des-Bois (FR); Boucart, Julien, 75014 Paris (FR)
(74) Mandataire: Fournier, Michel Robert Marie

(57) **Abrégé**

Deux couches semiconductrices de ce laser forment une jonction tunnel qui permet à un courant électrique assurant le pompage de ce laser de passer d'un miroir de Bragg semiconducteur à dopage N (20) à une couche d'injection à dopage P (16) appartenant à la structure amplificatrice de lumière (12,14,16). Ce miroir de Bragg coopère avec un autre miroir du même type ayant le même dopage (18) pour inclure cette structure dans une cavité optique de ce laser.

En variante la jonction tunnel peut être enterrée et localisée de manière à constituer un moyen de confinement pour ledit courant de pompage.

Ce laser est utilisable dans un réseau de communication à fibres optiques.

## Description

La présente invention concerne les lasers semiconducteurs à émission de surface c'est à dire du type dit VCSEL d'après l'anglais "Vertical Cavity Surface Emitting Laser". Elle permet la réalisation de miroirs ayant en même temps plusieurs qualités souhaitées pour la constitution de la cavité optique de tels lasers. Elle trouve en particulier application lorsque la lumière devant être émise par ces lasers doit avoir une longueur d'onde voisine de 850 nm, 980 nm, 1300 nm ou 1550 nm pour se situer dans l'une des fenêtres spectrales couramment utilisées dans les systèmes de communication à fibres optiques.

De manière connue cette lumière est engendrée dans la couche active d'une structure amplificatrice de lumière traversée par un courant de pompage et cette structure est incluse dans une puce monocristalline constituée d'un matériau semiconducteur à composition binaire du type III-V, c'est à dire d'arséniure de gallium AsGa ou de phosphure d'indium InP. Une telle puce est fabriquée par dépôt épitaxial de couches qui se superposent à partir d'un substrat. Dans la suite de la présente description et conformément à l'usage on considérera que ce substrat constitue la partie inférieure de la puce. Ce substrat ayant classiquement et avantageusement un dopage de type N et les dopages des couches de la structure amplificatrice formant nécessairement une séquence N I P, les couches supérieures de la puce ont usuellement des dopages de type P.

La cavité optique du laser est constituée par un miroir inférieur et un miroir supérieur formés respectivement sur une face inférieure et sur une face supérieure de la puce. Selon une disposition connue qui est adoptée dans le cadre de divers modes de mise en oeuvre de la présente invention, on fournit le courant de pompage à la structure amplificatrice à travers le miroir supérieur. La lumière à émettre s'échappe alors de cette cavité à travers le miroir inférieur. Dans le cas typique où le miroir supérieur n'occupe alors qu'une fraction de la surface horizontale de la puce et où il n'existe qu'une faible distance entre le miroir supérieur et la structure amplificatrice, cette disposition connue présente l'avantage d'assurer une coïncidence nécessaire entre deux zones de la surface de cette structure, à savoir celle qui est traversée par le courant de pompage et celle qui est incluse dans la cavité optique. Mais le passage de ce courant à travers le miroir supérieur pose un problème pour la réalisation de ce dernier. Ce problème tient au fait que ce miroir doit présenter à la fois, d'une part une réflectance très élevée, de préférence au moins égale à 99,5% pour permettre la croissance d'une oscillation optique dans la cavité, d'autre part une résistance électrique faible, de préférence inférieure à 10⁻⁴ Ω cm² si on considère la résistance par unité de surface, et en en tous cas suffisammnet faible pour permettre de faire circuler le courant de pompage, par exemple 10kA cm⁻², sans provoquer des pertes et un échauffement gênants par effet Joule.

Dans un premier laser connu semiconducteur à émission de surface on obtient une résistance électrique suffisamment faible en utilisant un miroir métallique. Mais la réflectance est alors au maximum voisine de 97% ce qui est en général insuffisant.

C'est pourquoi, dans un deuxième laser semiconducteur à émission de surface connu, on utilise un miroir de Bragg semiconducteur dopé. Un tel miroir est formé par la superposition de couches présentant des indices de réfraction alternés. Pour permettre un accord de maille cristalline avec la puce, ces couches sont classiquement constituées les unes d'arséniure et phosphure d'indium et de gallium et les autres de phosphure d'indium dans le cas d'une puce de phosphure d'indium. Pour la même raison elles sont classiquement constituées les unes d'arséniure d'aluminium et de gallium et les autres d'arséniure de gallium dans le cas d'une puce d'arséniure de gallium. Elles peuvent recevoir un dopage permettant d'obtenir la faible résistance électrique souhaitée.

Ce deuxième laser connu est décrit dans une communication de D. Babic et al, IPRM 95, Transverse mode and polarisation characteristics of double-fused 1.52 *µ*m vertical-cavity laser, page 773-776. Les deux miroirs de ce laser sont des miroirs de Bragg semiconducteurs. Pour permettre le passage du courant de pompage le miroir inférieur situé du coté N de la structure amplificatrice est dopé de type N et le miroir supérieur situé du côté P de cette structure est dopé de type P. Dans ce laser la puce est à base de phosphure d'indium pour permettre de fournir une lumière de 1520 nm de longueur d'onde. Pour limiter l'absorption de lumière grâce à une épaisseur limitée des miroirs, ces derniers sont à base d'arséniure de gallium. Lors de la fabrication de tels lasers chaque tel miroir doit être disposé sur une face, par exemple une face supérieure, d'une plaque à base de phosphure d'indium relativement épaisse. Pour cela ce miroir est d'abord fabriqué par dépôt épitaxial sur un substrat d'arséniure de gallium relativement épais. Puis il est assemblé à la plaque à base de phosphure d'indium par fusion thermique. Il la renforce mécaniquement de sorte que la face opposée de cette plaque, par exemple sa face inférieure, peut alors être attaquée pour amincir la plaque. Une deuxième opération du même type permet alors de déposer le deuxième miroir pour former une cavité optique de longueur convenable, cette longueur étant mesuré verticalement, c'est à dire selon l'épaisseur de la plaque. On peut aussi consulter à ce sujet un article de D.I. Babic, K. Streubel, R.P. Mirin, N.M. Margalit, E.L. Hu, D.E. Mars, L. Yang and K. Carey, Photon. Techn. lett. vol 7, 1225, 1995.

Le document EP 0709 939 A (Hewlett Packard Co) décrit un troisième laser semiconducteur à émission de surface connu. Ce laser est inclus dans une matrice de lasers de même type. Un but visé par ce document pour ce laser est qu'il soit commandé du côté à dopage de type N de sa structure semiconductrice amplificatrice de lumière ("N drive", ceci pour faciliter la commande) tout en étant formé sur un substrat de type N, (celui de la matrice, ceci pour éviter une diffusion dommmageable du zinc qui serait inclus dans ce substrat pour lui conférer le type de conductivité P). Malgré le fait que cette structure amplificatrice soit une structure NIP, c'est à dire que les dopages des deux côtés de cette structure sont de types opposés, le but visé est atteint grâce à une jonction tunnel formée pour cela dans la puce et interposée électriquement en série entre cette structure et ce substrat. Cette jonction est polarisée en inverse mais les deux couches qui la constituent recoivent des concentrations de dopage suffisantes pour lui permettre de transmettre le courant de pompage par effet tunnel. Les miroirs situés des côtés à dopage N et à dopage P de la structure amplificatrice sont des miroirs de Bragg ayant des types de dopage respectifs N et P. La jonction tunnel est formée entre le miroir à dopage de type P et le substrat.

Ces deuxième et troisième lasers connus présentent notamment l'inconvénient que les matériaux semiconducteurs constitutifs du miroir supérieur absorbent la lumière de ce laser dans une proportion telle que la réflectance de ce miroir est inférieure aux valeurs souhaitées.

Cet inconvénient résulte du fait que les matériaux semiconducteurs binaires à dopage P présentent pour cette lumière un coefficient d'absorption qui est plus important que celui des matériaux à dopage du type N. Ce coefficient croit avec la longueur d'onde de la lumière.

La présente invention a pour but général de permettre une fabrication économique de lasers semiconducteurs à émission de surface présentant des qualités souhaitées pour de tels lasers. Elle a entre autres le but plus particulier de permettre de conférer aux miroirs supérieurs de ces lasers à la fois une forte réflectance et une faible résistance électrique, notamment en vue d'une émission de lumière aux longueurs d'onde associées au phosphure d'indium.

Dans ces buts elle a pour objet un laser semiconducteur à émission de surface comportant une cavité optique et une structure amplificatrice de lumière située dans cette cavité et définissant le sens d'un courant de pompage de ce laser,
ce laser étant caractérisé par le fait que sa dite cavité optique est placée électriquement en série entre deux couches semiconductrices extrêmes appartenant à ce laser et ayant un même type de conductivité, deux couches semiconductrices de ce laser étant placées optiquement en série dans cette cavité et constituant une jonction tunnel permettant au dit courant de pompage de passer en série dans ladite structure amplificatrice et dans cette jonction dans un sens inverse de cette jonction.

Les indications données ci-dessus à propos de l'absorption de la lumière montrent que, dans le cadre des techniques actuellement connues, il est préférable que le dopage des miroirs d'un laser à émission de surface soit du type N lorsque ces miroirs sont tous deux des miroirs de Bragg constitués de couches semiconductrices. Dans ce cas la disposition objet de la présente invention permet d'atteindre le but plus particulier précédemment indiqué en permettant de constituer la cavité optique d'un tel laser par deux miroirs à dopage du type N. Il doit cependant être compris que, dans le cas où une évolution des techniques ferait au contraire apparaitre un avantage à constituer la cavité optique d'un tel laser par deux miroirs du type P, la même disposition permettrait d'obtenir cet avantage lors de la réalisation de tels lasers. Les types de dopage des couches semiconductrices des lasers à émission de surface qui seront décrits ci-après sont adaptés au cas où le dopage des miroirs de ce laser est du type N.

Par ailleurs, dans le cas où un substrat semiconducteur à dopage du type N porterait un miroir à couches diélectriques pour constituer le miroir inférieur d'un laser à émission de surface formé sur ce substrat, la présente invention permettrait de réaliser le miroir supérieur de ce laser sous la forme d'un miroir à couches semiconductrices à dopage du type N et d'obtenir ainsi les avantages résultant des caractéristiques électriques et optiques liées à ce type de dopage.

Dans ce cas aussi bien que dans celui où les deux miroirs de la cavité optique d'un tel laser sont constitués de couches semiconductrices, il doit être compris que la jonction tunnel prévue par la présente invention peut être située d'un côté ou de l'autre de la structure amplificatrice de lumière de ce laser.

A l'aide des figures schématiques annexées on va décrire ci-après, à simple titre d'exemple, cinq modes de mise en oeuvre de cette invention.

La figure 1 représente une vue en coupe verticale axiale d'un premier laser selon cette invention.

La figure 2 représente une vue en coupe verticale axiale d'un deuxième laser selon cette invention, ce deuxième laser constituant un mode préféré de mise en oeuvre de cette invention.

La figure 3 représente une vue en coupe verticale axiale d'un troisième laser selon cette invention.

La figure 4 représente une vue en coupe verticale axiale d'un quatrième laser selon cette invention.

La figure 5 représente une vue en coupe verticale axiale d'un cinquième laser selon cette invention.

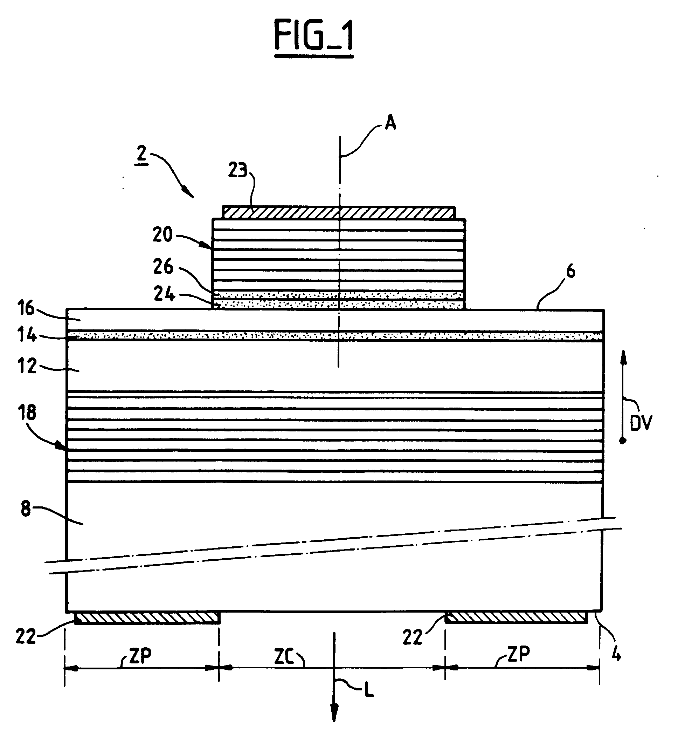

De même que celles des autres lasers donnés en exemple la puce du premier laser représenté à la figure 1 est constituée d'un ensemble semiconducteur essentiellement monocristallin. Cet ensemble a été réalisé par une succession de dépôts sur un substrat. Ce dernier a un axe A et une aire s'étendant dans un plan perpendiculaire à cet axe. Cet axe et cette aire constituent en même temps un axe et une aire de cette puce. Cette aire comporte une zone centrale ZC au voisinage de l'axe A et une zone périphérique ZP autour de cette zone centrale. Cette puce définit selon son épaisseur une direction verticale DV parallèle à l'axe A.

Plus particulièrement la puce 2 de ce premier laser présente une face inférieure 4 et une face supérieure 6 et comporte des couches mutuellement superposées. Sauf indication contraire ces couches sont constituées de phosphure d'indium. De cette face inférieure à cette face supérieure ces couches sont les suivantes :
- Le substrat 8. Ce substrat présente une épaisseur lui conférant une résistance mécanique permettant de manipuler cette puce, soit seule, soit, typiquement, sous la forme d'une plaque incluant plusieurs puces.
- Un miroir inférieur 18. Ce miroir est un miroir de Bragg semiconducteur ayant un dopage de type N. Il est formé sur la face supérieure 4 du substrat 8 en continuité avec ce substrat. Il s'étend sur l'ensemble des deux zones centrale ZC et périphérique ZP. Il est constitué de 40 à 50 paires de couches constituées chacune d'une couche de phosphure d'indium et d'une couche de phosphure et arséniure d'indium et de gallium. Ces couches ont des indices de réfraction alternés nH = 3,4 et nL = 3,17 et des épaisseurs optiques égales au quart de la longueur d'onde de la lumière du laser qui est par exemple 1520 nm. L'épaisseur totale de ce miroir est voisine de 10 *µ*m. Sa concentration de dopage est par exemple de 2.10¹⁸ cm⁻³. Ce miroir 18 pourrait aussi être constitué de couches diélectriques.
- Une première couche d'injection 12 à dopage de type N. Cette couche a une épaisseur de 1 *µ*m et une concentration de dopage de 5. 10¹⁷ à 2. 10¹⁸cm⁻³.
- Une couche active composite 14 apte à amplifier une lumière par recombinaison de porteurs de charges de types opposés. Cette couche comporte typiquement de cinq à huit puits quantiques contraints en compression. Ces puits et les barrières qui les séparent sont constitués de manière classique d'arséniure et phosphure d'indium et de gallium avec des proportions différenciées des composants. Cette couche peut aussi être constituée en matériau massif. Son épaisseur est typiquement comprise entre 100 et 400 nm environ.
- Une deuxième couche d'injection 16 à dopage de type P. Cette couche a une épaisseur de 1 *µ*m et une concentration de dopage de 5. 10¹⁷ à 2.10¹⁸cm⁻³. Le passage d'un courant de pompage du laser entre ces première et deuxième couches d'injection provoque l'injection de dits porteurs de charges de types opposés dans la couche active. Ces couches d'injection et la couche active constituent une structure amplificatrice de lumière. -Enfin un miroir supérieur 20. Ce dernier est lui aussi constitué par un miroir de Bragg semiconducteur ayant un dopage de type N et il est par exemple identique au miroir 18. Il est formé sur la face supérieure 6 de la puce 2 en continuité avec cette puce. Il s'étend seulement dans la zone centrale ZC. Il constitue avec le miroir inférieur la cavité optique du laser. Cette cavité s'étend selon l'axe A. Sa longueur, c'est à dire la distance entre les deux miroirs inférieur et supérieur, a une valeur convenable telle que 4 *µ*m.

Une partie inférieure du miroir supérieur 20 comporte, en superposition selon la direction verticale DV, à partir de la deuxième couche d'injection 16 et en continuité avec cette couche :
- une couche 24 ayant un dopage de type P, et
- une couche 26 ayant un dopage de type N.

Ces deux couches constituent une jonction semiconductrice que le courant de pompage du laser soumet à une polarisation électrique de sens inverse qui tend à s'opposer au passage de ce courant. Mais elles ont des concentrations de dopage accrues et notamment supérieures à celles de la deuxième couche d'injection 16 et du miroir supérieur 20. Plus précisément ces concentrations sont suffisamment élevées pour qu'un effet tunnel permette à cette jonction de conduire ce courant de pompage du miroir supérieur à la deuxième couche d'injection sans provoquer de chute de potentiel gênante. C'est pourquoi une telle jonction est appelée "jonction tunnel", les couches 24 et 26 étant respectivement appelées ci-après "première couche de jonction tunnel " et "deuxième couche de jonction tunnel".

Il est connu que des concentrations de dopage assez élevées pour constituer une jonction tunnel provoquent une forte absorption de la lumière dans le matériau dopé. Dans le cadre de la présente invention il a cependant été trouvé que, malgré la forte diminution de puissance qui pourrait résulter pour la lumière de la traversée d'un matériau semiconducteur ainsi dopé, il était possible, sans nuire à la conduction du courant, de limiter les épaisseurs des couches de jonction tunnel à des valeurs assez petites pour que l'absorption effective de la lumière soit suffisamment faible pour ne pas perturber sensiblement l'établissement d'une oscillation optique convenable dans la cavité optique du laser.

Plus précisément, de préférence, chacune des couches de jonction tunnel 24 et 26 présente une épaisseur comprise entre 10 et 300 nm et plus particulièrement entre 15 et 50 nm, environ. De préférence encore la couche de jonction tunnel 24 est constituée de phosphure et arséniure d'indium et de gallium et a une concentration de dopage au moins égale à 3. 10¹⁹ cm⁻³ et par exemple voisine de 8.10¹⁹ cm⁻³. De préférence aussi, la couche de connexion supérieure 26 a une concentration de dopage N supérieure à 10¹⁸ cm⁻³ et par exemple voisine de 3. 10¹⁸ cm⁻³.

Le premier laser donné en exemple comporte en outre:
- une électrode inférieure 22 formée sur le substrat 8, et
- une électrode supérieure 23 formée sur le miroir supérieur 20 et coopérant avec l'électrode inférieure 22 pour permettre de faire passer le courant de pompage du laser à travers la puce 2.

L'électrode inférieure 22 est formée sur le substrat 8 dans la zone périphérique ZP à l'exclusion de la zone centrale ZC de manière à permettre à la lumière L de ce laser de s'échapper de la puce 2 à travers la face inférieure 4 dans cette zone centrale. Celles desdites couches qui sont situées entre cette face inférieure et la couche active 14 ont des épaisseurs et des conductivités électriques leur conférant une conductivité selon les directions horizontales plus grande que celle qui résulte des épaisseurs et des conductivités électriques de celles desdites couches qui sont situées entre cette couche active et la face supérieure 6. Le rapport de ces deux conductivités selon les directions horizontales est suffisamment grand pour que le courant de pompage traversant la couche active 14 soit concentré dans la zone centrale ZC qui constitue une zone active pour la structure amplificatrice de lumière. De plus cette disposition assure une bonne uniformité de la répartition horizontale de ce courant à sa traversée de la couche active. Cette répartition pourrait être sensiblement la même si le miroir inférieur était du type à couches diélectriques et s'il était formé seulement dans la zone centrale, l'électrode inférieure étant alors formée dans la zone périphérique directement sur la face inférieure de la puce.

Dans la réalisation pratique d'une plaque comportant de nombreuses puces semiconductrices les zones centrales telles que ZC avaient des diamètres allant de 5 à 20 *µ*m et les zones périphériques telles que ZP des diamètres voisins de 0,25 mm. La tension nécessaire aux bornes du laser pour permettre son fonctionnement est apparue être voisine de 3 V.

Dans le laser décrit ci-dessus le miroir supérieur de type N était constitué de matériaux ayant la même maille cristalline que la puce de phosphure d'indium. Il est cependant possible de constituer ce miroir par des couches alternées d'arséniure de gallium GaAs et d'arséniure de gallium et d'aluminium GaAlAs, ces couches étant encore de type N, mais étant en désaccord de maille cristalline avec la puce de phosphure d'indium. La liaison entre un tel miroir et une telle puce peut être réalisée par une liaison par fusion selon le procédé appelé internationalement "wafer fusion". Elle peut aussi être réalisée grâce à une formation de ce miroir par un dépôt de ses couches constitutives par un procédé semblable à ceux qui sont connus pour réaliser des dépôts épitaxiaux. Un tel mode de dépôt conduit à la formation de couches qui peuvent être dites "métamorphiques".

La jonction tunnel peut alors être réalisée entre deux couches d'arséniure de gallium constitutives du miroir supérieur ou à l'interface entre une couche à composition quaternaire ayant la maille cristalline du phosphure d'indium et la première couche d'arséniure de gallium du miroir supérieur.

Une solution préférée dans le cas de couches métamorphiques serait cependant de réaliser cette jonction entre deux couches à composition quaternaire ayant la maille cristalline du phosphure d'indium.

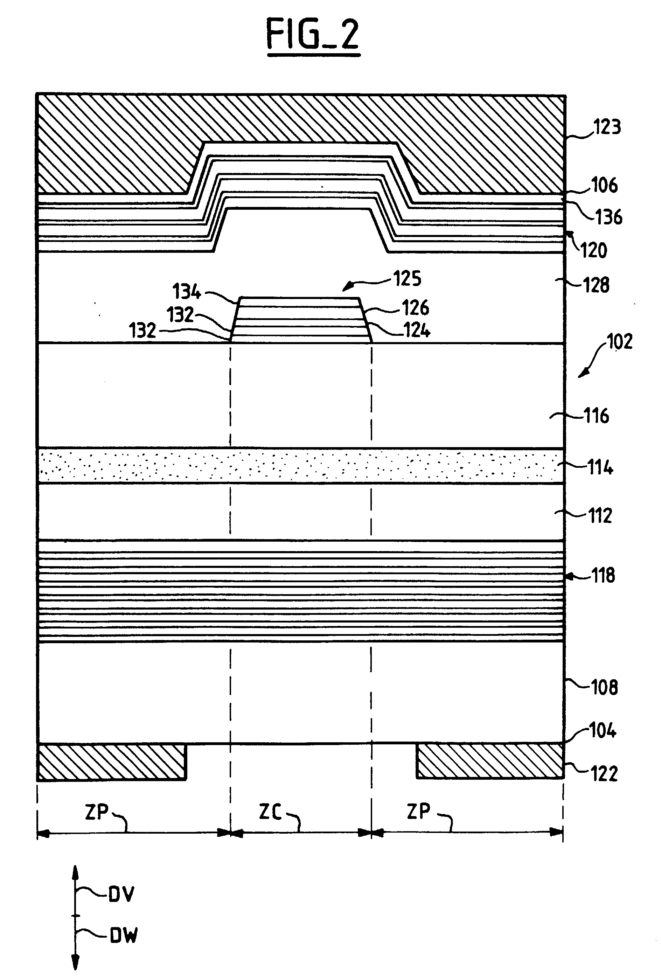

Un deuxième laser réalisé selon la présente invention va maintenant être décrit en se référant à la figure 2. D'une manière tout d'abord générale ce deuxième laser, de même que le premier laser décrit selon cette invention, comporte une succession de couches semiconductrices constituant une puce 102 et mutuellement superposées dans une aire ZP, ZC de cette puce. Une première partie de cette succession de couches semiconductrices constitue une structure amplificatrice de lumière 112, 114, 116 apte à amplifier une lumière interne à ce laser en réponse à un courant électrique unidirectionnel constituant un courant de pompage et traversant cette succession de couches dans une zone active de la dite aire. Une deuxième partie de cette succession comporte des couches ayant des concentrations de dopage suffisantes pour constituer une jonction tunnel apte à laisser passer ce courant de travail dans un sens inverse de cette jonction. Par rapport à ce premier laser, ce deuxième laser est caractérisé par le fait que lesdite couches ayant des concentrations de dopage suffisantes pour constituer une jonction tunnel sont des couches enterrées 124, 126 occupant seulement une zone de confinement de courant ZC constituée par une fraction de ladite aire de la puce de manière à confiner ledit courant de pompage dans cette zone lorsque ce courant traverse ladite deuxième partie de la succession de couches, cette zone de confinement de courant étant telle que ce courant de pompage soit concentré dans ladite zone active lorsqu'il traverse ladite structure amplificatrice de lumière.

Dans ce deuxième laser la jonction tunnel permet donc non seulement de faciliter si besoin est le passage du courant de pompage à travers un miroir supérieur 120, mais encore de constituer un moyen de confinement de ce courant au voisinage de la structure amplificatrice 112, 114, 116 sans nécessité pour cela de graver le miroir supérieur. Elle permet ainsi de réaliser la puce sous une forme planaire. Elle permet en même temps de diminuer la résistance électrique de la puce parce que la résistance d'accés présentée par le miroir supérieur non gravé est plus petite que celle qui serait présentée par un miroir gravé.

Un moyen de confinement a déja été utilisé pour le courant de pompage dans un quatrième laser semiconducteur à émission de surface connu. Dans ce quatrième laser connu le courant de pompage est introduit dans la puce à partir d'une électrode supérieure située dans la zone périphérique autour du miroir supérieur et c'est seulement ensuite que ce courant est dirigé vers la zone active centrale. Il peut être confiné dans cette zone par une couche bloquante qui est incluse dans la puce et qui est perçée d'une fenêtre au voisinage de l'axe, de sorte que cette fenêtre constitue une zone de confinement de courant.

Par rapport à ce quatrième laser connu, le deuxième laser selon la présente invention présente notamment l'avantage que son moyen de confinement de courant constitué à l'aide d'une jonction tunnel permet en même temps de faire passer le courant de pompage entre les deux dites couches semiconductrices extrêmes ayant un même type de conductivité. Ce deuxième laser selon cette invention va maintenant ête décrit de manière plus précise.

Conformèment à la figure 2, la puce 102 de ce laser présente une face inférieure 104 et une face supérieure 106 occupant ladite aire de cette puce. Elle définit deux directions verticales constituant une direction ascendante DV allant de cette face inférieure à cette face supérieure et une direction descendante DW opposée à cette direction ascendante. Les dites couches semiconductrices de cette puce constituent une structure composite en se succédant mutuellement dans cette structure dans l'ordre suivant selon une première des deux dites directions verticales :
- une première couche d'injection 112 ayant un dopage d'un premier type N et occupant ladite aire de la puce,
- une couche active 114 apte à amplifier une lumière par recombinaison de porteurs de charges de types opposés, cette couche active occupant ladite aire de la puce,
- une deuxième couche d'injection 116 ayant un dopage d'un deuxième type P opposé au dit premier type et occupant ladite aire de la puce, cette première couche d'injection, cette couche active et cette deuxième couche d'injection constituant ladite structure amplificatrice de lumière.

Dans les deuxième, troisième et quatrième lasers décrits ci-après ladite première direction verticale est la direction ascendante.

Conformément à la présente invention la structure composite comporte ensuite:
- une première couche de jonction tunnel 124 ayant un dopage dudit deuxième type P et une concentration de dopage accrue et occupant seulement ladite zone de confinement de courant,
- une deuxième couche de jonction tunnel 126 ayant un dopage dudit premier type et une concentration de dopage accrue et occupant seulement ladite zone de confinement de courant, et
- une couche d'accès 128 ayant un dopage dudit premier type et occupant ladite aire de la puce. Cette couche d'accès succède à ladite deuxième couche de jonction tunnel dans ladite zone de confinement de courant. Elle succède par contre à ladite deuxième couche d'injection dans la fraction de ladite aire de la puce extérieure à ladite zone de confinement de courant. Les dites concentrations de dopage accrues sont supérieures aux concentrations de dopage des première et deuxième couches d'injection et de la couche d'accès. Elles constituent les dites concentrations de dopage suffisantes pour que l'ensemble des deux dites couches de jonction tunnel constitue ladite jonction tunnel. Les concentrations de dopage de la deuxième couche d'injection et de la couche d'accès sont telles que l'ensemble de ces deux couches constitue une jonction bloquante pour le courant de pompage en dehors de ladite zone de confinement de courant.

Le laser donné en exemple comporte en outre :
- une électrode inférieure 122 formée au dessous de la dite structure composite,
- un miroir inférieur 118 formé au dessous de ladite structure composite,
- un miroir supérieur 120 formé au dessus de ladite structure composite et coopérant avec ledit miroir inférieur pour former la cavité optique de ce laser,et
- une électrode supérieure 123 formée au dessus de ladite structure composite et coopérant avec ladite électrode inférieure 122 pour permettre de faire passer ledit courant de pompage à travers ladite puce 102.

De préférence, les dites première et deuxième couches de jonction tunnel 124 et 126 sont constituées de matériaux ayant des indices de réfraction respectifs supérieurs à des indices de réfraction respectifs de ladite deuxième couche d'injection 116 et de ladite couche d'accès 128. Ces couches de jonction tunnel constituent alors au moins partiellement un localiseur de mode optique tel que la puissance présentée par une oscillation optique de ce laser dans ladite structure amplificatrice 112, 114, 116 soit sensiblement limitée aux bords de ladite zone active ZC avec l'aide de ce localiseur de mode. Cette oscillation optique est celle que le gain de la structure amplificatrice amène à se développer dans la cavité optique de ce laser. Ce localiseur de mode évite qu'une fraction sensible de la puissance de cette oscillation déborde de la zone active souhaitée et il évite en même temps que cette puissance s'affaiblisse sensiblement dans cette zone à l'approche des bords de celle ci. Autrement dit il permet d'obtenir une transition plus abrupte entre les densités de puissance optique à l'intérieur et à l'extérieur de la zone active.

Dans les lasers décrits ci-après la deuxième couche d'injection 116 et ladite couche d'accès 128 sont constituées de phosphure d'indium et les couches de jonction tunnel 124 et 126 sont constituées d'un matériau semiconducteur du type III-V à composition ternaire ou quaternaire. Il est connu qu'un tel matériau est composé d'au moins trois éléments dont un au moins appartient à chacun des types III et V.

Quel que soit le matériau de base de la puce du laser, phosphure d'indium, arséniure de gallium ou composé plus complexe, la supériorité des indices de réfraction des couches de jonction tunnel ne peut être utilement obtenue que par une différence entre d'une part les compositions de ces couches et d'autre part celles des matériaux semiconducteurs environnants. Il convient alors de tenir compte du fait que le passage entre deux matériaux semiconducteurs de compositions différentes s'accompagne d'une variation d'un niveau d'énergie dépendant du matériau considéré. Plus particulièrement, si on considère le diagramme représentatif des niveaux d'énergie susceptibles d'être occupés par les électrons dans ce matériau, diagramme sur lequel les énergies croissent vers le haut, une telle variation de niveau d'énergie est celle qui concerne la frontière haute de la bande de valence de ce matériau. Dans la mesure où, à l'exception du passage entre une couche d'injection et la couche active, une telle variation de niveau d'énergie est importante et brutale, elle crée une différence de potentiel constituant un obstacle au passage du courant de pompage du laser. Un autre obstacle au passage de ce courant de pompage pourrait par ailleurs être constitué par le fait qu'une couche de jonction tunnel à très grande concentration de dopage serait à la fois très fine et au contact d'une couche à faible concentration de dopage. Cette dernière pourrait alors capter les porteurs de charge de la couche de jonction tunnel et ainsi s'opposer à l'effet tunnel qui permet le passage de ce courant. La présence d'un obstacle tel qu'indiqué ci-dessus augmenterait la puissance électrique consommée par le laser et par conséquent aussi la puissance thermique qui doit être évacuée. Dans le laser donné en exemple l'importance de tels obstacles est limitée par le fait que certaines desdites couches semiconductrices constituent :
- un premier groupe de gradualité d'interface 132, 134 interposé entre ladite deuxième couche d'injection 116 et ladite première couche de jonction tunnel 124, et
- un deuxième groupe de gradualité d'interface 130 interposé entre ladite deuxième couche de jonction tunnel 126 et ladite couche d'accès 128. Chacun dé ces groupes de gradualité d'interface est constitué par au moins une couche de gradualité d'interface 130 interposée entre deux dites couches semiconductrices 116, 132 et chaque couche de gradualité d'interface a une composition et/ou une concentration de dopage intermédiaires entre les compositions et/ou les concentrations de dopage de ces deux couches semiconductrices, respectivement.

Le localiseur de mode précédemment mentionné est constitué par l'ensemble des couches de jonction tunnel et de gradualité d'interface ayant des compositions telles qu'elles leur confèrent des indices de réfraction plus élevés qu'aux matériaux environnants.

Plus particulièrement le deuxième laser donné en exemple de la présente invention est adapté à l'émission d'une lumière ayant une longueur d'onde de 1550 nm.

Avec l'aide de la figure 2 les électrodes et les couches semiconductrices de ce deuxième laser vont maintenant être décrites en détail. Sauf indication contraire les couches semiconductrices sont constituées de phosphure d'indium InP et occupent toute l'aire de la puce 102, c'est à dire l'ensemble des zones ZP et ZC. Les concentrations de dopage de ces couches sont indiquées après le type de conductivité N ou P qui leur est conféré par le dopage. Ces électrodes et couches se succèdent dans l'ordre suivant selon la direction DV :
- L'électrode inférieure 122 formée sur la face inférieure 104 de la pièce 102 et occupant la zone périphérique ZP.
- Le substrat 108. Ce substrat a une épaisseur de 80 microns et une concentration de dopage N de 2.10¹⁸ cm⁻³.
- Le miroir inférieur 118. Ce miroir est constitué constitué par un empilement périodique alterné de couches à composition binaire InP et de couches à composition quaternaire In_{0,66}Ga_{0,34}As_{0,74}P_{0,26,} Les couches à composition binaire ont une épaisseur de 122,2 nm et une concentration de dopage N de 10¹⁸ cm⁻³. Les couches à composition quaternaire ont une épaisseur de 112,7 nm et une concentration de dopage N de 10¹⁸cm⁻³ Le nombre de périodes est égal à 45.
- La première couche d'injection 112. Cette couche a une épaisseur de 395,4 nm et une concentration de dopage N de 10¹⁸cm⁻³.
- La couche active 114. Cette couche est composite et constituée par les couches élémentaires suivantes :
   . une première barrière ayant une composition In_{0,79}Ga_{0,21}As_{0,45}P_{0,55}, une épaisseur de 10 nm et non intentionnellement dopée,
   . un empilement périodique composé d'une alternance de puits quantiques ayant une composition In_{0,79}Ga_{0,21}As_{0,75}P_{0,25,} une épaisseur de 8 nm et non intentionnellement dopées, et de barrières ayant une composition In_{0,79}Ga_{0,21}As_{0,45}P_{0,55,} une épaisseur de 10 nm et non intentionnellement dopées. Le nombre de périodes est égal à 9.
- La deuxième couche d'injection 116. Cette couche a une épaisseur de 600 nm et une concentration de dopage de type P de 10¹⁸ cm⁻³.
- Un ensemble de jonction tunnel 125 occupant seulement la zone de confinement de courant ZC. Cet ensemble est constitué de cinq couches, à savoir,
   . une couche de gradualité d'interface 130, cette couche ayant une composition In_{0,79}Ga_{0,21}As_{0,45}P_{0,55}, une épaisseur de 20 nm et une concentration de dopage de type P de 10¹⁸cm^{-3,}
   . une couche de gradualité d'interface 132, cette couche ayant une composition In_{0,66}Ga_{0,34}As_{0,74}P_{0,26,} une épaisseur de 20 nm et une concentration de dopage de type P de 10¹⁸cm⁻³, ces couches 130 et 132 constituant le premier groupe de gradualité d'interface,
   . la première couche de jonction tunnel 124, cette couche ayant une composition In_{0,66}Ga_{0,34}As_{0,74}P_{0,26,} une épaisseur de 20 nm et une concentration de dopage du type P de 3 10¹⁹cm⁻³,
   . la deuxième couche de jonction tunnel 126, cette couche ayant une composition In_{0,66}Ga_{0,34}As_{0,74}P_{0,26,} une épaisseur de 40 nm et une concentration de dopage du type N de 3 10¹⁸ cm⁻ ³,
   . une couche de gradualité d'interface 134, cette couche ayant une composition In_{0,66}Ga_{0,34}As_{0,74}P_{0,26}, une épaisseur de 20 nm et une concentration de dopage du type N de 10¹⁸ cm⁻³, cette couche constituant le deuxième groupe de gradualité d'interface.
- La couche d'accès 128. Cette couche a une épaisseur de 500 nm et une concentration de dopage du type N de 10¹⁸cm⁻³.
- Le miroir supérieur 120 constitué par un empilement périodique alterné de couches à comosition binaire GaAs et de couches à composition ternaire Al_{0,9}Ga_{0,1}As. Les couches à composition binaire ont une épaisseur de 115 nm et une concentration de dopage du type N de 10¹⁸cm⁻³. Les couches à composition ternaire ont une épaisseur de 132 nm et une concentration de dopage du type N de 10¹⁸cm⁻³. Le nombre de périodes est égal à 30. Les interfaces entre les deux matériaux présentent une gradualité de composition de façon à faciliter le passage du courant électrique.
- Une couche d'accord de phase 136 ayant une composition GaAs, une épaisseur de 207,7 nm et une concentration de dopage du type N de 10¹⁸ cm⁻³.

Les couches semiconductrices ont des épaisseurs ajustées de façon à former une cavité résonante à la longueur d'onde de Bragg des miroirs (1550 nm pour l'exemple considéré).
- Enfin l'électrode supérieure 123.

La fabrication du laser qui vient d'être décrit a comporté les étapes suivantes, les dépôts épitaxiaux ayant été réalisés dans une enceinte d'épitaxie classique:
Etape 1 : Dépôt épitaxial des couches 118, 112, 114, 116, 125, ceci sur toute la face supérieure d'un substrat initial ayant une épaisseur suffisante pour permettre des manipulations ultérieures et de couches initiales dont une gravure ultérieure constituera l'ensemble de jonction tunnel 125.
Etape 2 : Définition de la zone de passage de courant par gravure desdites couches initiales de l'ensemble 125, la partie non gravée constituant cet ensemble. Cette zone est de forme carrée (dimension du côté 10 microns). Ses côtés sont orientés selon des axes [110] du réseau cristallin de la puce pour faciliter la reprise d'épitaxie lors de l'étape suivante.
Etape 3 : Dépôt épitaxial de la couche 128 sur toute la surface du substrat.
Etape 4 : Dépôt des couches successives du miroir supérieur 120 dans l'enceinte d'épitaxie.
Etape 5 :Dépôt de la couche 136 dans la même enceinte.
Etape 6 : Après extraction hors de l'enceinte d'épitaxie, dépôt d'une couche d'or épaissse de 250 nm sur le miroir supérieur permettant d'accroître le coefficient de réflexion du miroir et de former l'électrode supérieure 123.
Etape 7 : Amincissement du substrat par polissage de façon à former le substrat définitif 108 en lui donnant une épaisseur de 80 microns.
Etape 8 : Dépôt d'une couche métallique sur la face inférieure du substrat. Une ouverture centrale de diamètre 100 microns est gravée dans cette couche pour permettre l'émission laser au travers du substrat. La partie restante de cette couche constitue l'électrode 122.

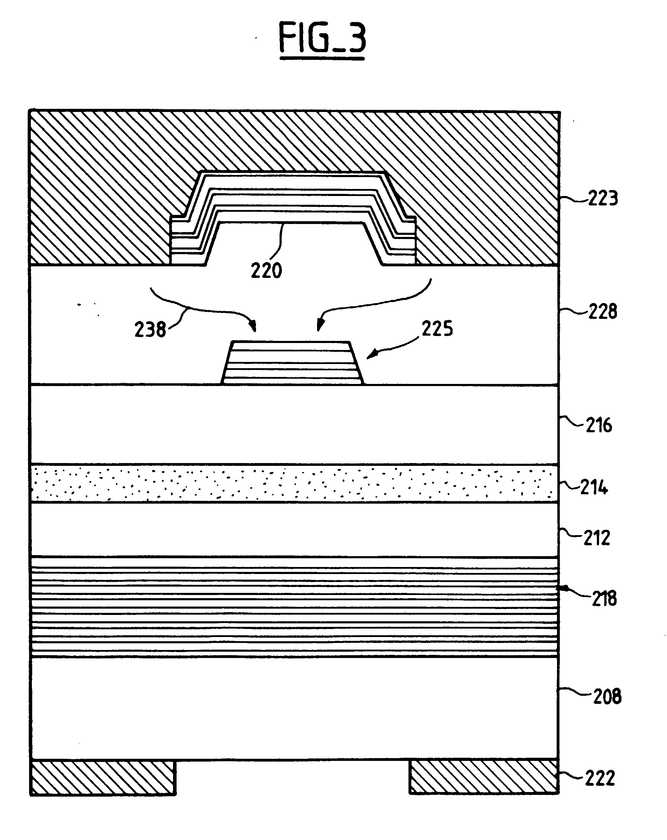

Les figures 3, 4 et 5 représentent des lasers constitués d'éléments analogues à ceux du deuxième laser de la figure 2. Lorsqu'un élément de l'un de ces trois lasers assure une fonction analogue à celle d'un élément de ce deuxième laser, il est désigné par le même numéro de référence sauf que le chiffre des centaines de ce numéro est le chiffre 2, le chiffre 3 ou le chiffre 4, respectivement, au lieu d'être le chiffre 1. Par ailleurs ces deux éléments peuvent être constitués de la même manière, sauf indication contraire.

Conformément à la figure 3 un troisième laser selon la présente invention comporte les éléments successifs suivants : une électrode inférieure 222, un substrat 208, un miroir inférieur 218, une première couche d'injection 212, une couche active 214, une deuxième couche d'injection 216, une couche d'accès 228, un ensemble de jonction tunnel 225, un miroir supérieur 220 et une électrode supérieure 223.

Ce troisième laser est généralement analogue au deuxième laser précédemment décrit. Il en diffère par le fait que son miroir supérieur 220 est constitué de couches diélectriques de sorte que le courant de pompage ne peut être injecté à travers ce miroir. Pour permettre l'injection de ce courant, ce miroir est gravé, c'est à dire qu'il est formé en deux étapes, une première étape étant le dépôt des couches diélectriques constitutives de ce miroir sur toute l'aire de la puce, la deuxième étape étant une gravure de ces couches pour ne les laisser subsister que dans une zone centrale qui peut par exemple déborder au delà de la zone de confinement de courant. L'électrode supérieure 223 est ensuite déposée sur toute l'aire de la puce de sorte qu'elle permet d'injecter le courant de pompage dans la couche d'accès 228 à partir de la fraction de l'aire de la puce extérieure au miroir supérieur. Ce courant suit ensuite un trajet incurvé qui est représenté par des flèches telles que 238 et qui lui permet d'atteindre l'ensemble de jonction tunnel 225. Cette disposition peut être appelée injection latérale. Elle peut être préférée dans certains cas à l'injection à travers le miroir supérieur utilisé dans le deuxième laser selon la présente invention. Dans de tels cas la présente invention permet que le substrat 208 et la couche d'accès 228 aient tous deux le type de conductivité N, ce qui, en ce qui concerne le passage du courant dans cette dernière couche et par rapport au cas où cette couche aurait le type de conductivité P, présente à la fois l'avantage d'une résistance d'accès moindre et celui d'une répartition plus uniforme de ce courant dans la zone active.

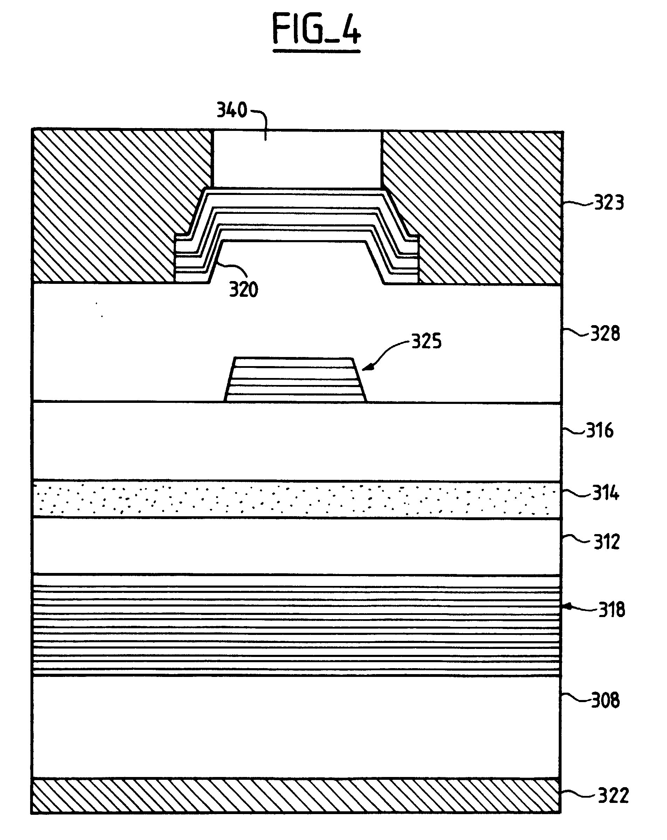

Conformément à la figure 4 un quatrième laser selon la présente invention comporte les éléments successifs suivants : une électrode inférieure 322, un substrat 308, un miroir inférieur 318, une première couche d'injection 312, une couche active 314, une deuxième couche d'injection 316, un ensemble de jonction tunnel 325, une couche d'accès 328, un miroir supérieur 320 et une électrode supérieure 323.

Ce quatrième laser est généralement analogue au troisième laser précédemment décrit selon la présente invention. Il en diffère par le fait que l'électrode inférieure 322 occupe toute la face inférieure de la puce et que l'électrode supérieure 323 est percée d'une fenêtre 340 pour permettre à la lumière du laser d'être émise par sa face supérieure à travers le miroir supérieur 320. Les réflectances respectives de ce miroir et du miroir inférieur 318 sont adaptées à cette disposition. Cette dernière présente notamment l'avantage d'éviter à la lumière d'avoir à traverser le substrat 308. Elle présente un inconvénient qui est déterminant dans certains cas d'application où la puissance thermique dissipée est importante. Cet inconvénient est que cette puissance est relativement difficile à évacuer à partir de la face inférieure de la puce parce qu'elle doit être recueillie à travers le substrat.

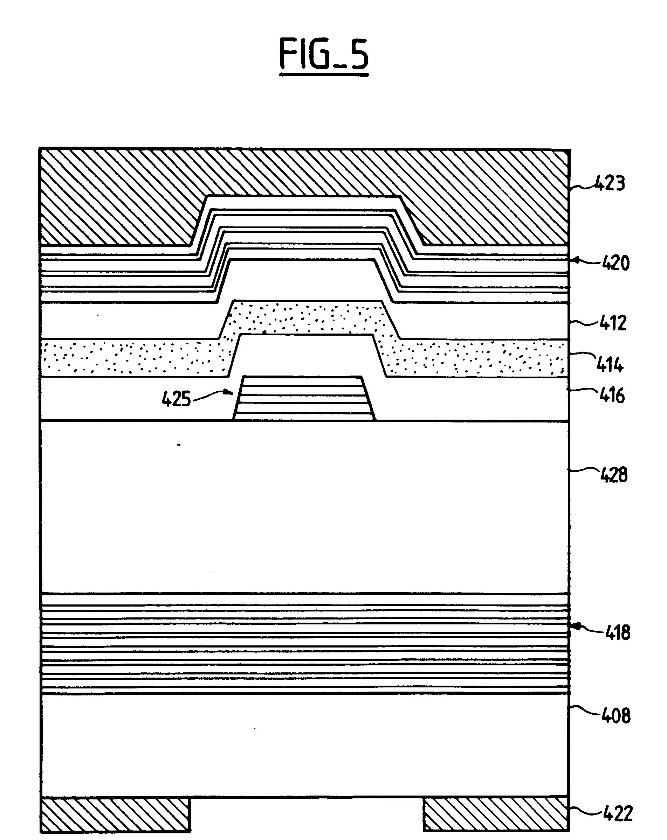

Conformément à la figure 5 un cinquième laser selon la présente invention comporte les éléments successifs suivants (de bas en haut) : une électrode inférieure 422, un substrat 408, un miroir inférieur 418, une couche d'accès 428, une dite deuxième couche d'injection 416, une couche active 414, une dite première couche d'injection 412, un ensemble de jonction tunnel 425, un miroir supérieur 420 et une électrode supérieure 423.

Ce cinquième laser est généralement analogue au deuxième laser précédemment décrit selon la présente invention. Il en diffère par le fait que son ensemble de jonction tunnel 425 est placé entre sa couche active 414 et son substrat 408, c'est à dire que l'ordre de succession des étapes de dépôts épitaxiaux est modifié et que ladite première direction verticale mentionnée dans la description générale de cette invention pour décrire la succession des couches de la dite structure composite est ici non plus la direction ascendante mais la direction descendante. Il en résulte une incurvation de la couche active, cette dernière présentant une protubérance dans la zone active, et une diminution correspondante de la distance entre cette couche et le miroir supérieur dans cette zone.

## Revendications

1. Laser semiconducteur à émission de surface, ce laser comportant une cavité optique (18,20) et une structure amplificatrice de lumière (12, 14, 16) située dans cette cavité et définissant le sens d'un courant de pompage de ce laser,
ce laser étant caractérisé par le fait que sadite cavité optique est placée électriquement en série entre deux couches semiconductrices extrêmes (8,20) appartenant à ce laser et ayant un même type de conductivité, deux couches semiconductrices de ce laser étant placées optiquement en série dans cette cavité et constituant une jonction tunnel permettant au dit courant de pompage de passer en série dans ladite structure amplificatrice et dans cette jonction dans un sens inverse de cette jonction.

2. Laser selon la revendication 1, ce laser comportant des couches semiconductrices constituant une puce (2) présentant une face inférieure (4) et une face supérieure (6), cette puce définissant deux directions verticales constituant une direction ascendante (DV) allant de cette face inférieure à cette face supérieure et une direction descendante (DW) opposée à cette direction ascendante, lesdites couches semiconductrices constituant dans cette puce une structure composite (12, 14, 16, 24, 26) en se succédant mutuellement dans cette structure dans l'ordre suivant selon une première des deux dites directions verticales :
- une première couche d'injection (12) ayant un dopage d'un premier type (N) et une concentration de dopage,
- une couche active (14) apte à amplifier une lumière par recombinaison de porteurs de charges de types opposés,
- une deuxième couche d'injection (16) ayant un dopage d'un deuxième type (P) opposé au dit premier type et une concentration de dopage, cette première couche d'injection, cette couche active et cette deuxième couche d'injection constituant ladite structure amplificatrice de lumière,
- une première couche de jonction tunnel (24) ayant un dopage dudit deuxième type (P) et une concentration de dopage, et
- une deuxième couche de jonction tunnel (26) ayant un dopage dudit premier type et une concentration de dopage, les dites concentrations de dopage des première et deuxième couches de jonction tunnel étant supérieures aux dites concentrations de dopage des dites première et deuxième couches d'injection et étant suffisantes pour que l'ensemble de ces deux couches de jonction tunnel constitue ladite jonction tunnel,
ledit laser comportant en outre :
- une électrode inférieure (22) formée au dessous de la dite structure composite,
- un miroir inférieur (18) formé au dessous de ladite structure composite,
- un miroir supérieur (20) formé au dessus de ladite structure composite et coopérant avec ledit miroir inférieur pour former ladite cavité optique de ce laser, et
- une électrode supérieure (23) formée au dessus de ladite structure composite et coopérant avec ladite électrode inférieure (22) pour permettre de faire passer ledit courant de pompage à travers ladite puce (2).

3. Laser selon la revendication 2, les dites première et deuxième couches d'injection (12, 16) étant constituées d'un composé binaire du type III-V, ladite première direction verticale étant ladite direction ascendante (DV), lesdits premier et deuxième types de conductivité étant respectivement les types N et P, ladite structure composite étant formée au dessus d'un substrat semiconducteur (8) ayant un dopage du type de conductivité N.

4. Laser selon la revendication 2, ce laser étant caractérisé par le fait que chacune des deux dites couches de jonction tunnel (24, 26) présente une épaisseur comprise entre 10 et 300 nm.

5. Laser selon la revendication 4, ladite épaisseur de chacune des couches de jonction tunnel (24, 26) étant comprise entre 15 et 50 nm environ.

6. Laser selon la revendication 2, ladite structure amplificatrice de lumière (112, 114, 116) occupant une aire (ZP, ZC) de ladite puce (102), ladite cavité optique occupant seulement une zone active (ZC) constituée par une fraction de cette aire, ce laser étant caractérisé par le fait que lesdites première et deuxième couches de jonction tunnel (124, 126) sont des couches enterrées occupant seulement une zone de confinement de courant (ZC) constituée par une fraction de ladite aire de la puce (102) et coïncidant sensiblement avec ladite zone active, ladite structure composite (112, 114, 116, 124, 126, 128) comportant en outre une couche d'accès (128) ayant un dopage dudit premier type et occupant ladite aire de la puce, cette couche d'accès succédant à ladite deuxième couche de jonction tunnel (126) dans ladite zone de confinement de courant (ZC) , cette couche d'accès succédant à ladite deuxième couche d'injection dans la fraction (ZP) de ladite aire de la puce extérieure à ladite zone de confinement de courant, lesdites concentrations de dopage de la deuxième couche d'injection et de la couche d'accès étant telles que l'ensemble de ces deux couches constitue une jonction bloquante pour ledit courant de pompage en dehors de ladite zone de confinement de courant.

7. Laser selon la revendication 6, ce laser étant caractérisé par le fait que lesdites première et deuxième couches de jonction tunnel (124, 126) sont constituées de matériaux ayant des indices de réfraction respectifs supérieurs à des indices de réfraction respectifs de ladite deuxième couche d'injection (116) et de ladite couche d'accès (128) , ces couches de jonction tunnel constituant un localiseur de mode optique tel que la puissance présentée par une oscillation optique de ce laser dans ladite structure amplificatrice (112, 114, 116) soit sensiblement limitée aux bords de ladite zone active (ZC) avec l'aide de ce localiseur de mode.

8. Laser selon la revendication 7, ladite deuxième couche d'injection (116) et ladite couche d'accès (128) étant constituées de phosphure d'indium, lesdites couches de jonction tunnel (124, 126) étant constituées d'un matériau semiconducteur du type III-V composé d'au moins trois éléments dont un au moins appartient à chacun des types III et V.

9. Laser selon la revendication 7, ce laser étant caractérisé par le fait que certaines desdites couches semiconductrices constituent :
- un premier groupe de gradualité d'interface (132, 134) interposé entre ladite deuxième couche d'injection (116) et ladite première couche de jonction tunnel (124), et
- un deuxième groupe de gradualité d'interface (130) interposé entre ladite deuxième couche de jonction tunnel (126) et ladite couche d'accès (128), chacun des dits groupes de gradualité d'interface étant constitué par au moins une couche de gradualité d'interface (130) interposée entre deux dites couches semiconductrices (116,132) et ayant une composition et/ou une concentration de dopage intermédiaires entre les compositions et/ou les concentrations de dopage de ces deux couches semiconductrices, respectivement.

10. Laser selon la revendication 2, ladite cavité optique ayant un axe (A) s'étendant selon une dite direction verticale (DV), ladite puce (2) comportant une zone centrale (ZC) au voisinage de cet axe et une zone périphérique (ZP) autour de cette zone centrale, une zone active de ladite couche active (14) coïncidant sensiblement avec cette zone centrale, ladite électrode supérieure (23) et ledit miroir supérieur (20) étant formés seulement dans cette zone centrale sur ladite face supérieure (6) de la puce (2), ladite électrode inférieure (22) étant formée dans ladite zone périphérique à l'exclusion de ladite zone centrale de manière à permettre à une lumière (L) émise par ce laser de s'échapper de ladite puce à travers ladite face inférieure (4) dans cette zone centrale, celles desdites couches semiconductrices qui sont situées entre cette face inférieure et ladite couche active (14) ayant des épaisseurs et des conductivités électriques suffisamment grandes pour permettre audit courant de pompage de traverser cette couche active dans ladite zone active.
